# DEMANDE DE BREVET EUROPEEN

(11) **EP 1 225 477 A1**
(43) Date de publication de la demande: **24.07.2002**
(21) Numéro de dépôt: 01810044.6
(22) Date de dépôt: 17.01.2001
(51) Int. Cl.: G03F 7/00

(54) **Procédé de fabrication et de marquage de composants micromécaniques réalisés par photostructuration et électroformage**

(71) Demandeur: Lorenz, Hubert, 1965 Savièse (CH); Fahrni, Nicolas, 1992 Les Agettes (CH)
(72) Inventeur: Lorenz, Hubert, 1965 Savièse (CH); Fahrni, Nicolas, 1992 Les Agettes (CH)
(74) Mandataire: Wenger, Joel-Théophile

(57) **Abrégé**

Cette invention concerne un procédé de fabrication d'un composant micromécanique produit selon ce procédé, ce procédé comprenant les étapes suivantes:
- irradiation au travers d'un premier photomasque (4), d'une première couche de photorésist (3) appliquée sur un substrat (1) recouvert d'une couche conductrice (2),
- polymérisation de la première couche de photorésist (3) et élimination de la couche de photorésist non irradiée,
- irradiation au travers d'un deuxième masque (4'), d'une deuxième couche de photorésist (3') d'une épaisseur supérieure à la première couche (3), appliquée sur le substrat (1) recouvert d'une couche conductrice (2),
- polymérisation de la deuxième couche de photorésist (3') et élimination de la couche de photorésist non irradiée,
- électro-formage (7) d'une épaisseur de métal correspondant à la pièce sur le substrat conducteur,
- séparation de la partie métallique du substrat et élimination du photorésist polymérisé.

Cette méthode permet d'obtenir une empreinte inimitable par d'autres procédés d'usinage tel que l'étampage.

## Description

Cette invention est du domaine des procédés de fabrication de micromoules et de microcomposants par photolithographie, et en particulier se propose de marquer les composants obtenus par ce procédé.

Le procédé de fabrication de microcomposants par irradiation d'une couche photosensible aux rayons ultraviolets est connu et est décrit dans la demande de brevet numéro EP 0 851 295.

Ce procédé est connu sous l'appellation LIGA (Lithographie Galvanoformung Abformung) et consiste à:
- déposer sur un substrat une couche de 10 à 1000 µm d'un photorésist négatif;
- effectuer à travers un masque une irradiation au moyen d'un synchrotron ou par une exposition de rayons ultraviolets;
- développer, c'est-à-dire éliminer par des moyens chimiques les portions de photorésist non irradiés et créer de ce fait une cavité en photorésist.
- Electroformer un métal dans cette cavité afin d'obtenir le composant micromécanique.

L'avantage de cette technique est de réaliser des composants d'une très grande précision en X et Y et avec une épaisseur allant jusqu'à 1 mm. Il est également possible d'appliquer le procédé en plusieurs étapes pour obtenir un composant en plusieurs niveaux, chaque niveau étant construit sur le précédent.

Ces pièces de très petite taille et d'une grande précision sont utilisées entre autre par l'horlogerie. Cette industrie est connue pour sa production de produits à haute valeur ajoutée et qui font l'objet de copies de plus en plus fidèles quant à la similitude des pièces. Ainsi, ces contrefacteurs provoquent un tort important aux fabricants réputés, car les pièces contrefaites sont de plus en plus difficiles à détecter.

Le but de la présente invention se propose de non seulement produire des pièces d'une grande qualité, mais disposant également d'une signature mécanique identifiant indubitablement le fabricant.

Ce but est atteint par une méthode de fabrication comprenant les étapes suivantes:
- irradiation à travers un premier photomasque, d'une première couche de photorésist appliquée sur un substrat recouvert d'une couche conductrice,
- polymérisation de la première couche de photorésist et élimination de la couche de photorésist non irradiée. Cette couche est le positif de la signature mécanique.
- irradiation à travers un deuxième photomasque, d'une deuxième couche de photorésist d'une épaisseur supérieure à la première couche, appliquée sur le substrat recouvert d'une couche conductrice,
- polymérisation de la deuxième couche de photorésist et élimination de la couche de photorésist non irradiée,
- dépôt d'une couche métallique d'une épaisseur correspondant au composant à réaliser par électro-formage sur le substrat conducteur,
- séparation de la partie métallique du substrat et élimination du photorésist.

Le but de la première couche n'est pas de contribuer à la formation de la pièce, mais d'inscrire avec la précision inégalable de la technique dite LIGA, une signature mécanique qui servira de marque de reconnaissance pour la pièce. On utilisera de préférence une structure dense donc difficilement imitable par usinage conventionnel.

La présente invention sera mieux comprise à la lumière des dessins annexés, pris à titre non limitatifs, dans lesquels:
- la figure 1 illustre la préparation de la première couche,
- la figure 2 illustre le substrat développé avec la première couche, cette couche est le positif de la signature mécanique.
- la figure 3 illustre la préparation de la seconde couche,
- la figure 4 illustre la seconde couche développée,
- la figure 5 illustre la création du composant par électro-formage,
- la figure 6 illustre la pièce finale obtenue,
- la figure 7 illustre le substrat développé recouvert d'une couche d'or,
- la figure 8 représente la création du composant par électro-formage dans la variante avec revêtement or,
- la figure 9 représente la pièce finie avec revêtement or dans les cavités,
- la figure 10 représente une variante réalisée par trois applications de couches photorésist.

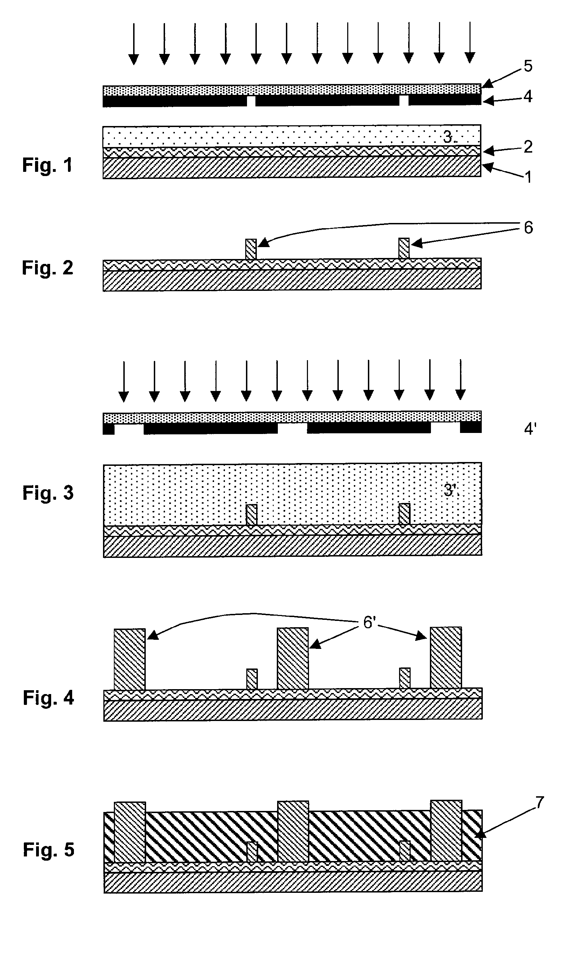

Selon la figure 1, le substrat 1 est généralement une plaque de verre sur laquelle est déposée une couche conductrice 2 réalisée par un évaporation de chrome et d'or. Sur cette couche conductrice est déposée une couche photorésist 3 sensible aux rayons ultraviolets. Cette ensemble est chauffé à une température entre 90 et 95°C durant une période dépendant de l'épaisseur de la couche.

Cette couche est ensuite irradiée par une source à ultraviolets à travers une plaque en verre 5 sur laquelle a été structuré un motif en chrome 4. Cette plaque avec sa découpe de chrome est appelée un photomasque.

La lumière arrivant parfaitement perpendiculairement sur la plaque 5, seul les portions de photorésist non protégées par le motif en chrome seront irradiées.

Un recuit de la couche de photorésist provoque la polymérisation dans les zones ayant reçu le rayonnement UV. Cette partie polymérisée devient insensible à la plupart des solvants par opposition aux autres zones qui sont dissoutes par un solvant.

On obtient ainsi la structure de la figure 2 avec les régions polymérisées 6 qui ont une épaisseur égale à la couche de photorésist déposée initialement et dont la largeur est définie par le premier photomasque 4. Cette couche est le positif de la signature mécanique.

Ces opérations sont répétées à la figure 3 avec une épaisseur de photorésist 3' supérieure à la première couche 3 de manière à recouvrir les structures polymérisées 6. L'irradiation par rayons UV se fera au travers d'un deuxième photomasque 4'.

Le recuit et la dissolution du photorésist non polymérisé nous donne la structure de la figure 4 avec les différentes portions de polymère 6 et 6' durcit.

L'étape suivante consiste à charger cette structure de particules métalliques par électroformage pour former un bloc métallique 7 épousant les structures polymérisées tel que représenté à la figure 5.

La dernière étape consiste à libérer le bloc métallique 7 et à éliminer la structure positive représentée à la figure 5.

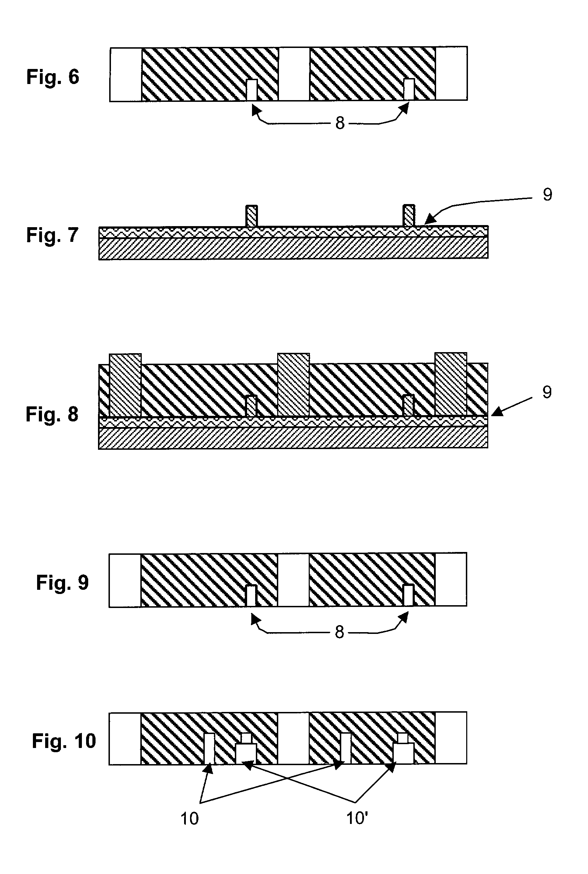

Le résultat est illustré à la figure 6 qui est une coupe de la pièce obtenue. Les faces supérieure et inférieure sont rodées pour obtenir une grande planéité et l'aspect fini.

Les rainures ou cavités 8, visibles de l'extérieur, forment alors une signature mécanique tel qu'un logo de l'entreprise ou une marque de qualité.

Selon une variante de l'invention, l'intérieur des cavités 8 obtenues grâce à la méthode décrite ci-dessus, est revêtu d'une couche d'une couleur différente telle que de l'or.

Après l'obtention de la structure illustrée à la figure 2, une couche métallique d'un autre aspect tel que de l'or est déposée par un procédé d'évaporation pour former un revêtement 9 ayant entre 30 à 100 nm. Lors de l'électroformage tel qu'illustré à la figure 5, cette masse métallique se dépose sur le revêtement 9 d'or.

Après le retrait du substrat 1 et des portions polymérisées, la couche d'or se retrouve sur toute la surface de la pièce. Il est de plus facile, par rodage, d'éliminer l'or sur la surface extérieure pour que demeure uniquement le revêtement d'or à l'intérieur des cavités 8.

La méthode décrite précédemment mettant en oeuvre deux couches peut être utilisée pour obtenir des variantes plus complexes.

La figure 10 illustre un exemple réalisé par une triple application. Les cavités 10' sont réalisées en deux passages, le premier produisant la grande dimension de la cavité 10' et le second produisant les cavités 10 et la petite dimension des cavités 10'.

Il est à noter que ce procédé se distingue par rapport à l'étampage ou à d'autres méthodes connues par les points suivants :
- la largeur des cavités peut être inférieure à 50 µm
- il n'y a pas de limitation quant à la distance latérale entre deux cavités
- la profondeur de la cavité peut être jusqu'à 10 fois plus grande que sa largeur.
- toutes les arêtes de la signature sont vives et sans arrondis.
- le fond des cavités est plat et aucune déformation de matière n'est observable.

Ces différences montrent que la signature obtenue par la méthode selon l'invention permet d'authentifier la marque de fabrication de la pièce.

Selon une forme simplifiée de l'invention, le premier photomasque sert également à former la signature mécanique, en plus de définir les contours de la pièce. De ce fait, la signature a la même épaisseur que la pièce elle-même. Cette exécution permet d'obtenir des pièces signées en une seule opération et conserve les caractéristiques particulières obtenues par la technique LIGA.

## Revendications

1. Méthode de fabrication d'une pièce métallique comportant une empreinte comprenant les étapes suivantes:
- irradiation à travers d'un premier photomasque (4), d'une première couche de photorésist (3) appliquée sur un substrat (1) recouvert d'une couche conductrice (2),
- polymérisation de la première couche de photorésist (3) et élimination de la couche de photorésist non irradiée,
- irradiation à travers un deuxième photomasque (4'), d'une deuxième couche de photorésist (3') d'une épaisseur supérieure à la première couche (3), appliquée sur le substrat (1) recouvert d'une couche conductrice (2),
- polymérisation de la deuxième couche de photorésist (3') et élimination de la couche de photorésist non irradiée,
- dépôt d'un couche métallique (7) d'une épaisseur correspondant au composant à réaliser par électro-formage sur le substrat conducteur,
- séparation de la partie métallique du substrat et élimination du photorésist.

2. Méthode selon la revendication 1, **caractérisée en ce qu'**elle consiste à évaporer une couche métallique fine sur la structure obtenue après première polymérisation, ladite couche métallique adhérant sur l'apport métallique lors de la phase d'électro-formage.

3. Composant micromécanique obtenue selon la revendication 1, **caractérisé en ce qu'**il comporte sur une de ses faces des cavités dont le fond présente des angles parfaitement droits.

4. Composant micromécanique selon la revendication 3, **caractérisé en ce que** la distance entre deux parois desdites cavités peut être inférieure à 0.5mm.

5. Composant micromécanique selon les revendications 3 ou 4, **caractérisé en ce que** les parois de la cavité sont recouvertes d'une couche métallique tel que de l'or.

6. Méthode de fabrication d'une pièce métallique comportant une empreinte comprenant les étapes suivantes:
- irradiation au travers d'un photomasque (4), d'une première couche de photorésist (3) appliquée sur un substrat (1) recouvert d'une couche conductrice (2), ledit masque définissant les contours de la pièce et le tracé de la signature mécanique,
- polymérisation de la couche de photorésist (3) et élimination de la couche de photorésist non irradiée,
- électroformage (7) d'une épaisseur de métal correspondant à la pièce sur le substrat conducteur,
- séparation de la partie métallique du substrat et élimination du photorésist polymérisé.
